Europäisches Patentamt

(19) European Patent Office

Office européen des brevets

(11) Publication number: 0 305 195
A2

# (12) EUROPEAN PATENT APPLICATION

(21) Application number: 88307920.4

(22) Date of filing: 26.08.88

(51) Int. Cl.⁴: **H 01 L 21/205**

(30) Priority: 27.08.87 US 90073

(43) Date of publication of application:
01.03.89 Bulletin 89/09

(84) Designated Contracting States: DE FR GB NL

(71) Applicant: TEXAS INSTRUMENTS INCORPORATED
13500 North Central Expressway
Dallas Texas 75265 (US)

(72) Inventor: Lindberg, Keith J.
800 Hwy, 1417 S, Apt. No. 826
Sherman Texas 75090 (US)

Smith, Jerry D.
Route 7, Box 209
Sherman Texas 75090 (US)

Bean, Ken L.
Route 2, Box 126B
Celina Texas 75009 (US)

(74) Representative: Abbott, David John et al
Abel & Imray Northumberland House 303-306 High
Holborn
London, WC1V 7LH (GB)

(54) Continuous chemical vapor deposition growth of strain layer superlattices using conventional CVD reactors.

(57) A method of continuous deposition of alternate layers of two different semiconductor materials onto a substrate from source gases containing these different semiconductor materials which includes exposing the substrate to a periodic variation in the ratio of silicon to silicon-germanium concentrations in the source gases.

Fig. 1

EP 0 305 195 A2

Bundesdruckerei Berlin

Description

# CONTINUOUS CHEMICAL VAPOR DEPOSITION GROWTH OF STRAIN LAYER SUPERLATTICES USING CONVENTIONAL CVD REACTORS

## TECHNICAL FIELD

The present invention relates to a method of growing strain layer superlattices utilizing chemical vapor deposition and utilizing conventional chemical vapor deposition reactors.

## BACKGROUND OF THE INVENTION

A "heterojunction" is formed by the interface of two dissimilar semiconductor materials which can either have the same or opposite conductivity types. Devices having a plurality of thin layers of a first semiconductor composition interleaved with a plurality of thin layers of a second semiconductor composition can produce what is now known as a "superlattice structure". Such structures exhibit enhanced electron and/or hole mobility and can stop the propagation of dislocations through the lattice. The conventional method of producing such structures has been to use molecular beam epitaxy (termed "MBE") and lay down each layer one at a time. For example, in a silicon and silicon-germanium layer structure on a silicon substrate, the larger germanium atoms result in the alloy layer having a larger lattice dimension than that of pure silicon. Thus, a silicon layer deposited over a silicon-germanium alloy layer places the silicon layer in tension laterally and the silicon-germanium layer in compression laterally. Once all such layers have adjusted to each other, they will each be under a strain due to the readjustment each must make to the others. Such a strain is known to produce a superlattice structure in which mobility is enhanced over that in the epitaxial silicon grown under the same conditions and with the same average carrier concentration. Although good thickness control is obtained with the MBE technique it produces only a low growth rate with a corresponding high contamination level and is very expensive.

A National Aeronautics and Space Administration Report No. CR-3903 published June, 1985 by Isoris S. Gergis et al. discloses the use of chemical vapor deposition in growing films of silicon and silicon-germanium on bulk silicon substrates. The germanium content in the alloy layers was between 5 and 20%. After one layer was deposited, the supply of gas for that layer was shut off, the chamber purged of residual gas and then the alternate source of gas for the next layer directed to the reactor chamber. The same steps were repeated between each layer of deposited semiconductor material. Due to the growth temperature being approximately 1,000 °C., maintaining the semiconductor film at such temperatures while purging the germanium source gas from the reactor results in diffusion of the germanium into the silicon during this time. Additionally, the need for purging of the reactor chamber between layer deposition of separate layers increases significantly the time for fabrication of such an interleaved set of films.

## SUMMARY OF THE INVENTION

The present invention relates to a method of continuous deposition of alternate layers of two different semiconductor materials onto a substrate from source gases containing these different semiconductor materials which includes exposing the substrate to a periodic variation in the ratio of silicon to silicon-germanium concentrations in the source gases.

Such a periodic variation can be achieved by establishing a low mean residence gas time in a reactor containing the substrate and periodically changing the silicon and silicon-germanium source gases.

Alternatively, the periodic variation can also be achieved by rotating the substrate in a barrel type epitaxial reactor so as to cause the gas boundary layer over the substrate to periodically vary in response to a varying source gas velocity in the reactor. A changing gas boundary layer thickness results in a changing ratio in the concentration of silicon and silicon-germanium reaching the substrate.

As a third alternative, the periodic variation can also be achieved by moving the substrate in turn past gas flow streams of first and second ratios of silicon to germanium source gases.

## BRIEF DESCRIPTION OF THE DRAWINGS

The novel features believed characteristic of the invention are set forth in the appended claims. The invention itself, however, as well as other features and advantages thereof, will be best understood by reference to the detailed description which follows, read in conjunction with the accompanying drawings, wherein:

Figure 1 is a schematic plan view of an arrangement for periodically varying the gas boundary layer thickness over a substrate by mounting the slice on a susceptor and rotating the latter in a reactor chamber into which is injected a source gas;

Figure 2 is a schematic graph of the gas boundary layer thickness as a function of susceptor position;

Figure 3 is a schematic graphical presentation showing a typical germanium profile in a molecular beam epitaxy formed superlattice;

Figure 4 is a schematic graphical presentation showing the germanium profile in a superlattice formed by chemical vapor deposition according to a preferred embodiment of the present invention;

Figure 5 is diagram in elevation of a barrel type epitaxial reactor with source gas directed into the reactor from the top against a baffle;

Figure 6 is a diagram in elevation of a pancake type epitaxial reactor with the slice rotated on a pedestal and with two different injection jets for injecting two different gases;

Figure 7 is an elevation view of a barrel type epitaxial reactor into which gas is injected at two different locations near the top and the susceptor is mounted on a rotatable shaft through the top of the reactor;

Figure 8 is high volume type epitaxial reactor that has a short residence time and into which can be injected source gases at various locations around a rotating drum;

Figure 9 is a hot wall furnace type epitaxial reactor;

Figure 10 is a diagram of a horizontal slab type epitaxial reactor; and

Figure 11 is a vertical hot wall furnace type epitaxial reactor.

DETAILED DESCRIPTION WITH REFERENCE TO THE DRAWINGS

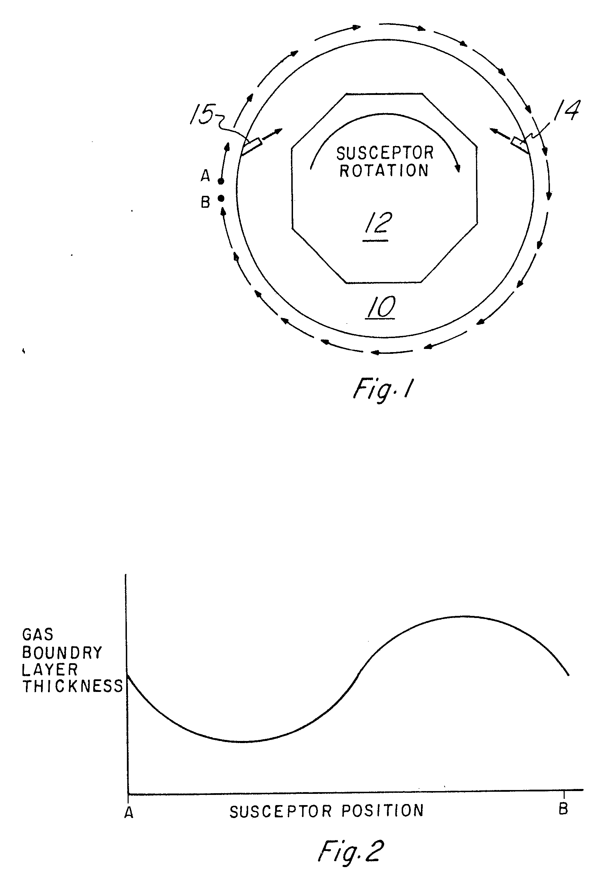

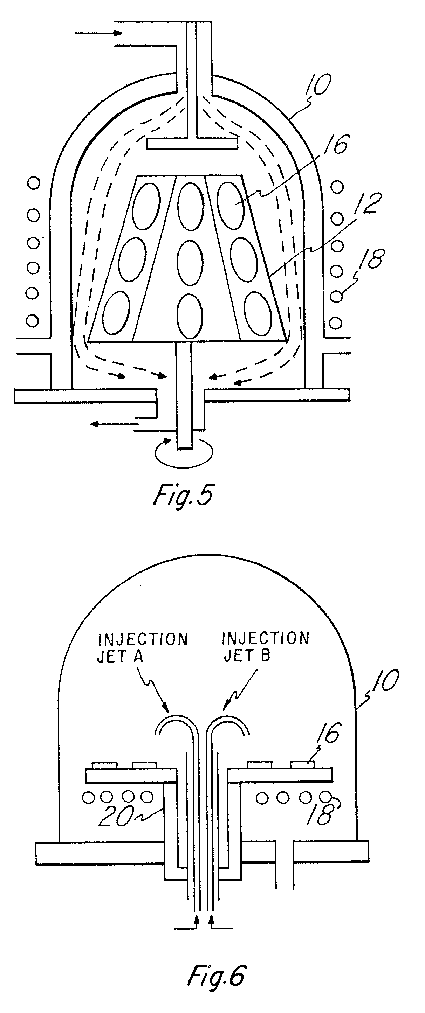

Monocrystalline silicon slices 16 (see Figure 5) are mounted on a susceptor 12 which has a hexagonal cross section as seen in Figure 1. The silicon substrates were oriented in a (100) direction. The susceptor 12 is rotatable mounted in a reactor vessel 10 into which is directed source gas through nozzles 14 and 15 located at spaced apart locations through the walls of the reactor 10. The silicon slices 16 (as seen in Figure 5) on susceptor 12 of vessel 10 are then heated by induction coils 18 or infrared located around the outside of the reactor vessel 10 as seen in Figure 5 to a temperature in the range of 800 to 1250 °C. Source gases $SiH_4$ and $GeH_4$ in a hydrogen atmosphere are directed through nozzles 14 and 15 into the interior of the chamber 10 as shown in Figure 1. Some other suitable source gases for the deposit of silicon are $SiH_2Cl_2$, $SiHCl_3$, and $SiCl_4$ and for germanium, $GeCl_4$. The deposition rate for given conditions will depend on the type of source gases used. When the slice position is at the top of the page as seen in Figure 1, the gas flow over the slice will be a maximum and the gas boundary layer thickness can be shown to be at a minimum thickness as a result. A maximum boundary layer thickness is achieved when the slice is at the bottom of the page furthest away from the gas nozzles as seen in Figure 1.

Figure 2 shows the variation in gas boundary layer thickness in moving clockwise from position A in Figure 1 to position B. Since the deposition rate of silicon will vary at a different rate than will the corresponding deposition rate of germanium with a changing boundary layer thickness, rotation of the susceptor will result in a periodic variation in the percent by weight of germanium deposited in the alloy $Si_{1-x}Ge_x$ over the silicon substrate 16. Using such a technique it is possible to vary the germanium content in germanium rich regions in the range of less than 1% to 65% by atomic weight silicon in germanium. Epitaxial films with individual layer thickness periodicity in the range of 20 to 10,000 Angstroms have been deposited. Typically, the rate of rotation of the susceptor is about 9 seconds per cycle.

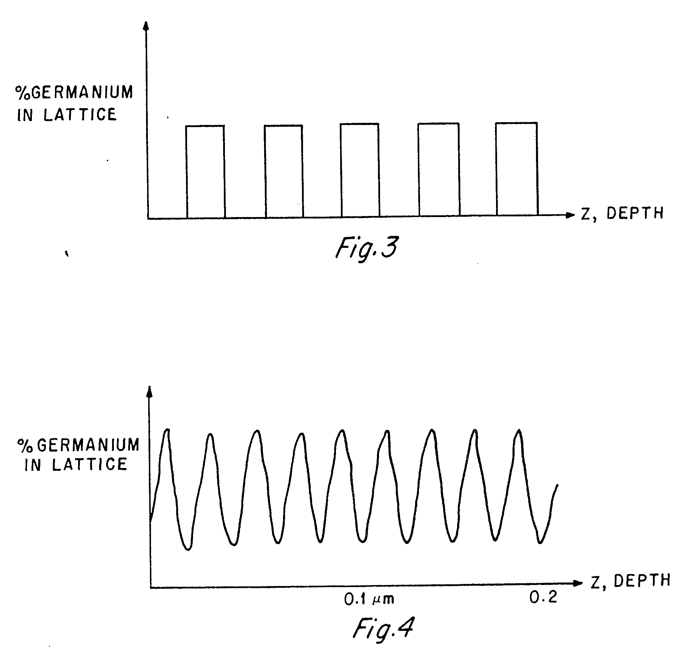

The resultant film composition as verified by transmission electron microscope and secondary ion mass spectroscopy exhibits a sinusoidal type of variation in the atomic % of germanium in tho lattice as shown schematically in Figure 4. Rather than injecting gas as shown in Figure 1, the gas may be fed into the chamber through the top against a baffle as in the barrel type of reactor shown in Figure 5 and exhausted out the bottom.

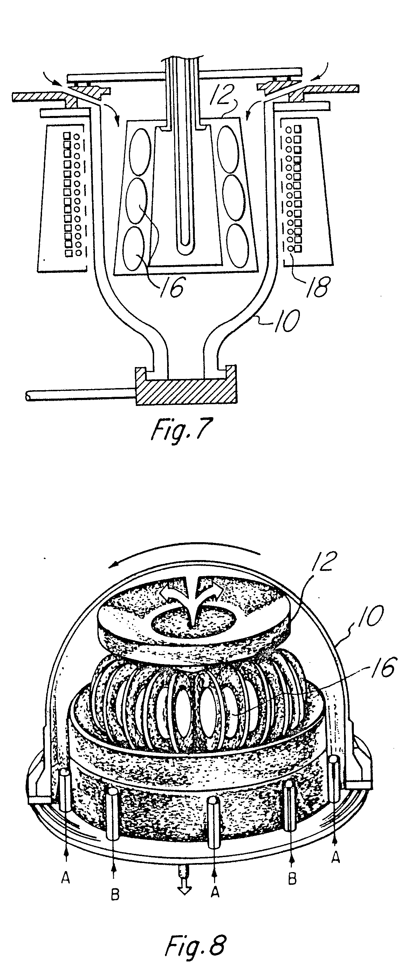

An alternative method of producing a periodic variation in the atomic % of germanium in a silicon-germanium alloy is to expose the substrate to separate gas flows with different ratios of silicon-germanium source gases. Configurations which can be used to carry out this method are shown in Figures 6, 7, s and 11. In Figures 6 to 11 like parts are referenced by the same reference numbers. In this case the slice is moved (or rotated) past two or more gas flow streams with different ratios of silicon to germanium source gases. The pumping speed of the gas exhaust in this case, however, is chosen so as to provide a gas mean residence time that is less than the time to rotate the slice through a half cycle. The most efficient such reactor is that shown in Figure 8. The latter reactor 10 has a rotatable susceptor 12 on which a plurality of slices 16 are mounted in a vertical orientation. Gas sources A and B are injected into the chamber 10 at alternating spaced intervals around the periphery. The gas mean residence time in this type of geometry must be relatively small so that the primary gas to which a slice is exposed in a given position is that coming from the nozzle directly below the slice.

In the reactor shown in Figure 11 substrates are mounted on a wafer boat which rotates counterclockwise inside a furnace tube 38. Two different gas sources are injected in through respective injection tubes 34 and 36 and is exhausted out through exit 40.

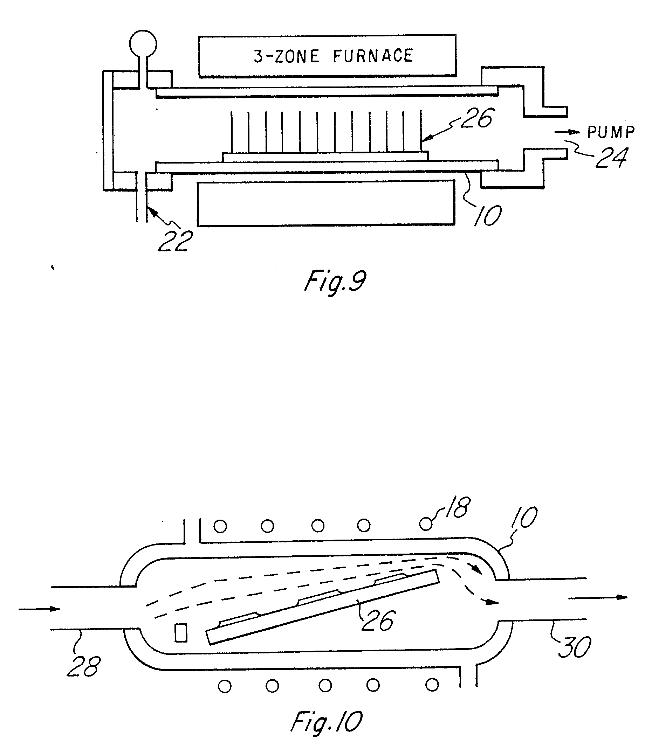

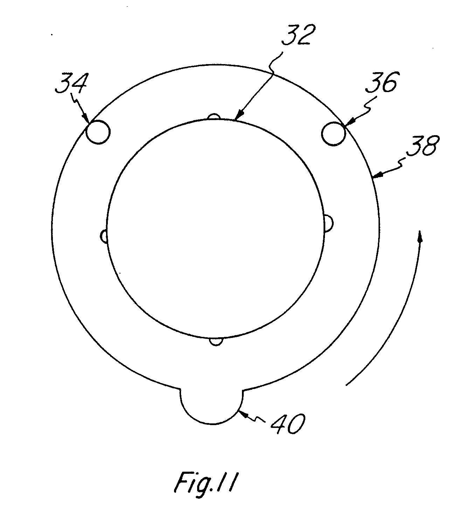

Yet another alternative method of producing a periodic variation in the atomic % of germanium in a silicon-germanium alloy is to periodically change the silicon and germanium source gas flow into the reactor chamber 10 as is done in the reactors shown in Figures 9 and 10. Figure 9 shows a hot wall reactor in which gas enters through a nozzle 22 at one end and passes through an elongated reactor 10 past the slices which are mounted vertically and out through an exit 24. The reactor of Figure 10 has the slices mounted inside a chamber 10 on an inclined support 26 and gas enters from one end 28 and flows past the slices and out another end 30.

The strain layer superlattices produced in accordance with the above exhibit increased electron and/or hole mobility. This increased mobility results in increased device speed and allows silicon-germanium strain superlattice to be used for high speed circuitry applications that currently require the more expensive and difficult to process III-V compound circuits. Moreover, contamination is considerably reduced over that experienced with molecular beam epitaxy techniques.

While this invention has been described with reference to an illustrative embodiment, this description is not intended to be construed in a limiting sense. Various modifications of the illustrative embodiment, as well as other embodiments of the invention, will be apparent to persons skilled in the art upon reference to this description. It is, therefore, contemplated that the appended claims Will cover any such modifications or embodiments as fall within the true scope of the invention.

## Claims

1. A method of of continuous deposition of alternate layers of two different semiconductor materials onto a substrate from source gases containing said semiconductor materials in a reactor at a selected temperature including exposing the substrate to a periodic variation in the ratio of the two different semiconductor materials from the source gases.

2. A method according to claim 1, wherein the substrate is silicon and the semiconductor materials are germanium and silicon.

3. A method according to claim 2, wherein the first layer deposited is a germanium rich layer.

4. A method according to claim 1, wherein said exposing step includes rotating said substrate in a reactor so as to cause the boundary layer of gas over said substrate to periodically vary.

5. A method according to claim 1, wherein the growth temperature is in the range of 800 to 1250°C.

6. A method according to claim 1, wherein said exposing step includes moving said substrate past spaced apart alternate sources of each of said two different semiconductor materials so as to deposit alternating layers of said two different semiconductor materials onto said substrate.

7. A method according to claim 1, wherein said exposing step includes establishing a gas mean residence time less than the time to grow a layer of semiconductor film and then periodically changing the source gas flow from a stream for depositing a first type of semiconductor to a stream for depositing a second type of semiconductor material on said substrate.

8. A method according to claim 3, wherein the periodicity of the layers is in the range of 40 to 20,000 Angstroms.

9. A method according to claim 1, wherein said reactor is a barrel type epitaxial reactor.

10. A method according to claim 1, wherein said reactor is a pancake type epitaxial reactor.

11. A method according to claim 1, wherein said reactor is a high volume type epitaxial reactor.

12. A method according to claim 1, wherein said reactor is a horizontal slab type epitaxial reactor.

13. A method according to claim 1, wherein said reactor is a hot wall furnace type epitaxial reactor.

Fig. 1

Fig. 2

%GERMANIUM
IN LATTICE

Z, DEPTH

*Fig.3*

%GERMANIUM
IN LATTICE

0.1 μm          0.2

Z, DEPTH

*Fig.4*

Fig.5

INJECTION
JET A

INJECTION
JET B

Fig.6

EP 0 305 195 A2

Fig.7

Fig.8

3-ZONE FURNACE

26

→ PUMP
24

10

22

Fig.9

18    10

26

28    30

Fig.10

*Fig.11*